Europäisches Patentamt

(19) European Patent Office

Office européen des brevets

(11) Numéro de publication: **0 079 280**
**B1**

(12) **FASCICULE DE BREVET EUROPÉEN**

(45) Date de publication du fascicule du brevet:
**13.08.86**

(21) Numéro de dépôt: **82402030.9**

(22) Date de dépôt: **04.11.82**

(51) Int. Cl.⁴: **G 01 S 1/30, H 03 L 7/06**

(54) **Dispositif de compensation d'une horloge locale et dispositif de radio-navigation, notamment OMEGA, le comprenant.**

(30) Priorité: **10.11.81 FR 8121092**

(43) Date de publication de la demande:
**18.05.83 Bulletin 83/20**

(45) Mention de la délivrance du brevet:
**13.08.86 Bulletin 86/33**

(84) Etats contractants désignés:
**BE DE GB IT NL SE**

(56) Documents cité:
**FR-A-2 255 744**
**US-A-3 818 477**
**US-A-3 840 821**
**US-A-3 936 763**
**US-A-3 936 828**
**US-A-3 968 493**

(73) Titulaire: **THOMSON- CSF, 173, Boulevard Haussmann, F-75379 Paris Cedex 08 (FR)**

(72) Inventeur: **Collomby, Michel, THOMSON- CSF SCPI 173, bld Haussmann, F-75379 Paris Cedex 08 (FR)**
Inventeur: **Bec, Daniel, THOMSON- CSF SCPI 173, bld Haussmann, F-75379 Paris Cedex 08 (FR)**

(74) Mandataire: **El Manouni, Josiane, THOMSON- CSF SCPI 19, avenue de Messine, F-75008 Paris (FR)**

EP 0 079 280 B1

**0 079 280**

## Description

La présente invention a pour objet un dispositif de compensation d'une horloge et un dispositif de radio-navigation, notamment OMEGA, le comprenant.

Les horloges locales des dispositifs électroniques sont généralement réalisées à l'aide d'oscillateurs à quartz de différents types selon la précision désirée.

Les quartz de qualité courante présentent une bonne stabilité à court terme, mais une dérive en température assez importante (typiquement $10^{-5}$ pour une variation de température de $40°C$), ainsi qu'une dérive à très long terme due au vieillissement (environ $10^{-6}$ à $10^{-5}$). Les dérives thermiques sont relativement lentes, par exemple $10^{-6}$ en une heure, mais par contre, à un instant donné, la fréquence produite à partir du quartz présente une précision de l'ordre de $10^{-5}$.

Des quartz de meilleure qualité sont disponibles, par exemple des quartz compensés en température, dont la précision est de $10^{-6}$.

Certains systèmes de radio-navigation mettent en oeuvre des émissions par créneaux, de fréquences normalisées qui sont produites à partir d'une horloge de très haute stabilité, généralement une horloge atomique dont la précision est de l'ordre de $10^{-12}$. La fréquence reçue par les récepteurs de radio-navigation correspondants a une stabilité moindre à cause des phénomènes de propagation des signaux radioélectriques, lesquels correspondent à des variations de l'ordre de $10^{-9}$ à $10^{-8}$, et de l'effet Doppler, lequel correspond pour un bateau à des variations de l'ordre de $10^{-8}$ à $10^{-7}$ Dans le fonctionnement en navigation suivant le mode hyperbolique, les récepteurs réalisent une comparaison entre les phases des signaux de différentes émissions, par comparaison avec une horloge locale de référence assez précise, sans toutefois qu'une précision aussi grande que celle des émissions reçues soit exigible.

Par exemple, le système de navigation hyperbolique OMEGA met ainsi en oeuvre huit stations émettrices A à H qui suffisent à réaliser une couverture à l'échelle de la planète, avec une précision de localisation de l'ordre du mile nautique. La réception s'opère généralement par détection des émissions de trois, et parfois quatre, émetteurs et par traitement de trois des fréquences émises tour à tour par chacun des émetteurs à savoir 10,2, 11,33 et 13,6 KHz.

Les émissions OMEGA sont réalisées sous la forme de formats de durée 10 secondes, chaque format comprenant une série de 8 créneaux de durée 1,25 s pendant lesquels chaque station émet sur une fréquence et une durée différente des autres dont les valeurs sont données par la définition du système OMEGA.

Deux stations n'émettant donc jamais simultanément sur la même fréquence, un récepteur OMEGA doit classiquement être capable de recevoir les trois fréquences précitées et d'assurer le traitement des informations contenues dans les créneaux, à savoir:

- la durée des émissions dans chaque créneau, qui permet d'identifier les stations émettrices et de situer le début des formats;
- la phase des émissions, par comparaison avec une horloge locale, de manière à retrouver la position du mobile portant le récepteur, en déterminant les phases relatives des différentes émissions.

Les récepteurs de navigation de l'art antérieur et notamment les récepteurs OMEGA utilisent une horloge locale comprenant un oscillateur compensé en température (par exemple TCXO), permettant d'assurer une précision meilleure que $10^{-6}$. Il s'agit d'un dispositif coûteux (quartz de haute qualité et/ou quartz thermostaté).

Le document US-A-3 936 763 divulgue un dispositif de radionavigation comprenant:

- un circuit de réception d'au moins une émission sous forme de créneaux d'au moins un émetteur piloté par une horloge de haute précision;
- un circuit de synchronisation pour produire une synchronisation au moins approximative sur les créneaux d'émission dudit émetteur;
- un circuit de comparaison pour échantillonner ladite émission à une fréquence d'échantillonnage sous-multiple de la fréquence de l'horloge locale et pour en déduire une comparaison entre la fréquence de l'horloge locale et celle de ladite émission.

Le document US-A-3 968 493 divulgue un comparateur de phase numérique appliqué à un dispositif de radio-navigation et comportant, entre autres, un circuit de correction pour corriger la phase d'une horloge locale.

La présente invention a pour objet un procédé de compensation de dérive d'horloge permettant d'accroître la précision d'une horloge locale, notamment dans le cas d'un dispositif de radio-navigation.

L'invention concerne ainsi un procédé de compensation de la dérive d'une horloge locale, consistant à:

- recevoir au moins une émission ($F_0$, $F_1$ ou $F_2$) sous forme de créneaux d'au moins un émetteur piloté par une horloge de haute précision;
- produire une synchronisation au moins approximative sur les créneaux d'émission dudit émetteur;
- échantillonner ladite émission à une fréquence d'échantillonnage ($F_E$) sous-multiple de la fréquence de l'horloge locale et en déduire une comparaison entre la fréquence de l'horloge locale et celle de ladite émission;
- corriger la fréquence de l'horloge locale, en fonction du résultat de ladite comparaison,

procédé dans lequel la fréquence d'échantillonnage ($F_E$) est définie par division de celle de l'horloge et égale nominalement à celle de ladite émission ou à un sous-multiple de celle-ci, dans lequel plusieurs émissions de fréquence différente sont reçues sous forme de créneaux d'au moins un émetteur, et dans lequel ladite fréquence d'échantillonnage est un sous-multiple commun desdites fréquences d'émission, caractérisé en ce qu'à l'issue de l'opération d'échantillonnage sont obtenus des couples d'impulsions ($a_0$, $b_0$; $a_1$, $b_1$; $a_2$, $b_2$)

2

dont la récurrence correspond à ladite fréquence d'échantillonnage, afin de produire un échantillonnage ($a_0$, $a_1$, $a_2$) et un échantillonnage en quadrature ($b_0$, $b_1$, $b_2$) pour une fréquence donné (respectivement $F_0$, $F_1$ ou $F_2$), et en ce que le décalage temporel entre ladite fréquence d'échantillonnage ($F_E$) et au moins une fréquence d'au moins une émission est calculé périodiquement.

L'invention concerne également un dispositif pour la mise en oeuvre du procédé de compensation d'horloge locale. L'invention porte également sur l'utilisation d'un tel dispositif dans un dispositif de radio-navigation destiné à déterminer la position d'un mobile.

L'invention sera mieux comprise dans la description qui va suivre donnée, à titre d'exemple non limitatif, en prenant en considération le système de navigation OMEGA, en se reportant aux dessins ci-annexés où:
- la figure 1 représente un diagramme selon l'invention;
- la figure 2 est un schéma associant les trois fréquences utiles d'un système OMEGA aux 8 émetteurs assurant la couverture radio;
- la figure 3 correspond à l'émission de la fréquence $F_0$ par 3 des émetteurs OMEGA;
- les figures 4 et 5 illustrent deux mises en oeuvre d'une comparaison de phase selon l'invention;
- les figures 6 et 7 sont des diagrammes d'un échantillonnage selon le mode de réalisation de la figure 4;
- la figure 8 illustre un mode de réalisation de l'invention où on associe les différents émetteurs d'une même fréquence OMEGA pour retrouver la dérive de l'horloge à compenser;
- les figures 9 et 10 sont deux variantes de l'action compensatrice sur l'horloge;
- la figure 11 est un mode de réalisation de l'invention avec un microprocesseur.

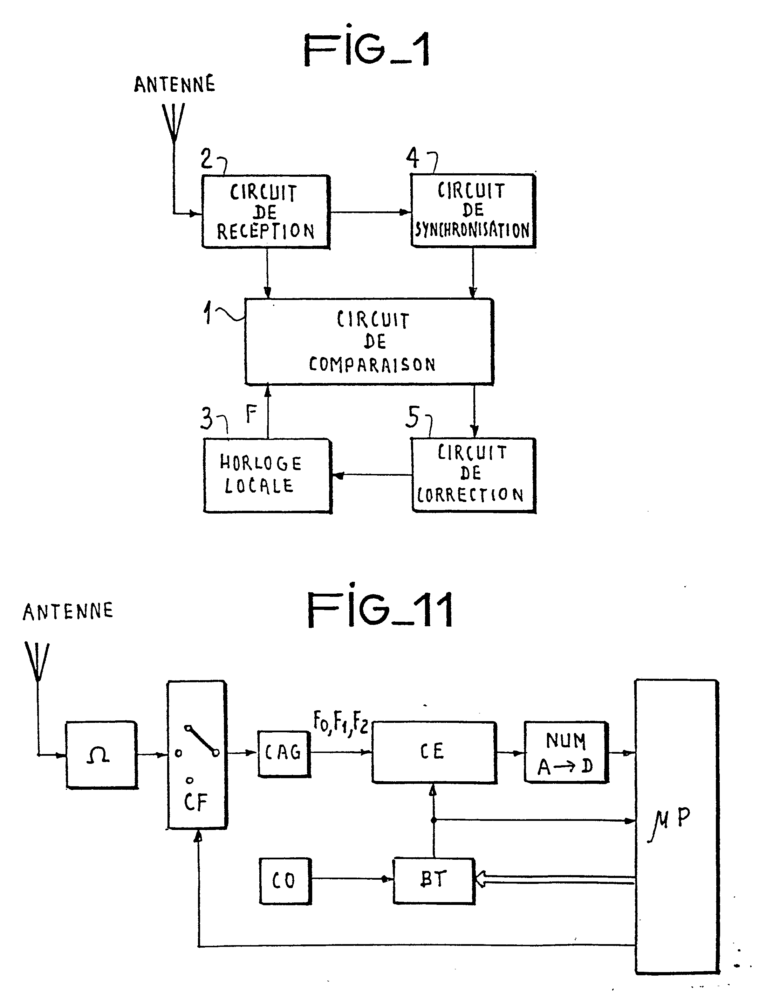

Selon la figure 1, un circuit de comparaison 1 échantillonne à une fréquence d'échantillonnage $F_E$ sous-multiple de la fréquence d'une horloge locale 3, au moins une émission pilotée par une horloge de haute précision et reçue par un circuit 2 de réception pour en déduire une comparaison entre la fréquence F de l'horloge locale (3) et celle de ladite émission. Un circuit de synchronisation 4 permet à cet effet au circuit de comparaison 1 de se centrer sur les créneaux d'émission de la station, c'est-à-dire les instants où la station émet un signal de fréquence donnée et d'amplitude sensiblement constante. Le circuit 5 élabore une correction à partir du résultat de la comparaison. Cette correction est utilisée pour compenser l'horloge locale 3 dont la précision intrinsèque est bien inférieure à celle de l'émission reçue.

Une telle extraction du temps à partir d'émissions, en général de radio-navigation, nécessite non seulement que les émissions soient pilotées du sol avec une précision suffisante, mais aussi que la durée d'un créneau d'émission ou de la somme des créneaux des stations utilisées, fournisse une information suffisante pour entamer une procédure initiale de recherche de synchronisation et de verrouillage des boucles de phase. Par exemple, si une synchronisation est possible avec le système OMEGA avec une horloge non compensée, ceci est très difficile dans le système LORAN, en raison de la brièveté des émissions, qui correspondent plus à des impulsions qu'à des créneaux. Enfin, et dernière condition, les émissions ne doivent pas être l'objet de perturbations de propagation excessives.

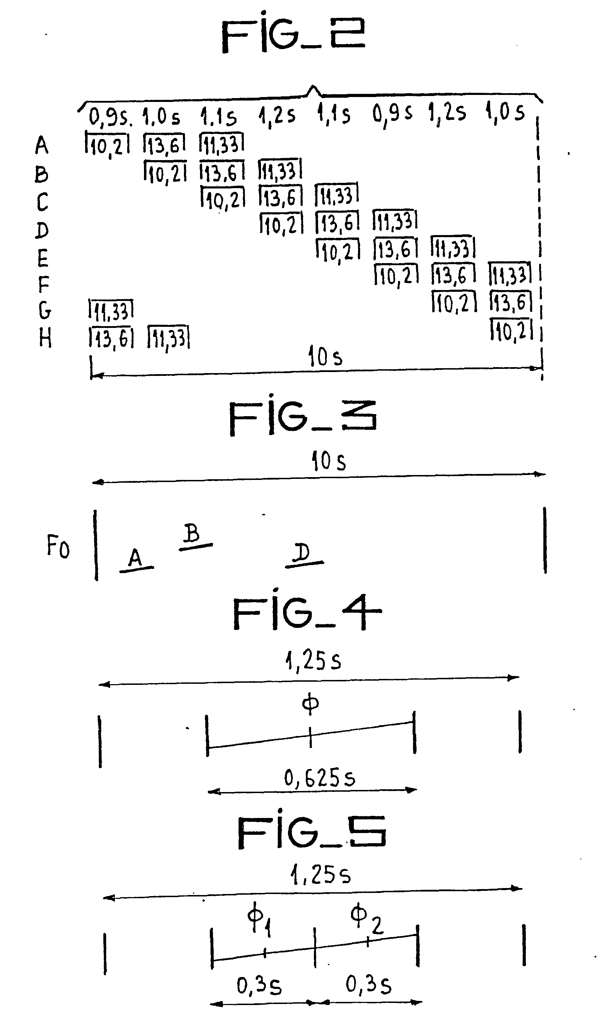

Selon la figure 2, les 8 émetteurs OMEGA A à H émettent chacun entre autres trois fréquences $F_0$ = 10,2 KHz, $F_1$ = 11,33 KHz, et $F_2$ = 13,6 KHz à des intervalles de 10 secondes, chaque créneau d'émission proprement dit pouvant durer de 0,9 à 1,2 s et les différents créneaux étant séparés par des intervalles donnés. Un format OMEGA consiste en 8 créneaux de 1,25 s, les émissions des émetteurs OMEGA étant centrées sur lesdits créneaux. Les séquences d'émission dès diverses fréquences par chaque émetteur sont décalées de la valeur d'un créneau, de telle sorte que deux frequences identiques ne sont jamais émises simultanément par deux émetteurs différents.

On se bornera dans ce qui suit à la description d'un récepteur utilisant trois fréquences de navigation. L'utilisation de la quatrième fréquence commune (11,05 KHz) et des fréquences uniques permet de perfectionner le dispositif et est évidemment possible de manière connue en soi.

Sur la figure 3, on a représenté en fonction du temps la fréquence $F_0$ émise par les émetteurs A B et D qui peuvent être reçus dans une région donnée, suivant sa répartition dans un format OMEGA.

Les trois fréquences $F_0$, $F_1$ et $F_2$ sont celles généralement utilisées pour la mesure de position du mobile portant le récepteur. Le système OMEGA est en effet essentiellement fondé sur la reconnaissance des différences de phase entre des couples choisis de créneaux d'émission de fréquence 10,2 KHz. Les deux autres fréquences servent essentiellement à la résolution des ambigüités, étant donné que des signaux de même phase sont obtenus en des points de l'espace distants d'une longueur d'onde de l'émetteur considéré.

Si on considère maintenant que ta phase de chacune des trois fréquences $F_0$, $F_1$ et $F_2$ est mesurée par rapport à une horloge locale qui présente une certaine précision à un instant donné, mais qui fluctue par dérive lente, ta phase de chacune des fréquences telle qu'ette est donc vue par l'horloge locale va fluctuer avec une pente représentée par tes traits inclinés de la figure 3 et correspondant à la précision de l'horloge locale à l'instant donné, mais en sens inverse. Les valeurs de ces trois pentes vont varier très lentement dans le temps car la dérive de l'horloge locale est elle-même très lente. Ces pentes sont représentées par des traits inclinés, car pendant des temps assez courts, elles sont assimilabies à des droites.

Selon la figure 4, pour chaque créneau OMEGA de 1,25 s, on définit une zone utile de largeur 0,625 s environ centrée sur celui-ci et qui correspond à la fraction utile commune des émissions OMEGA de tous les créneaux, lesquelles durent comme on l'a dit en tout entre 0,9 et 1,2 s autrement dit, les créneaux de 625 ms vont toujours rester compris dans les créneaux émis de 0,9 à 1,2 s. C'est pendant cet intervalle que l'on va réaliser par échantillonnage la mesure de la phase pour les trois fréquences $F_0$, $F_1$ et $F_2$ et pour les 8 émetteurs de manière à en déduire les phases moyennes $\Phi$.

**0 079 280**

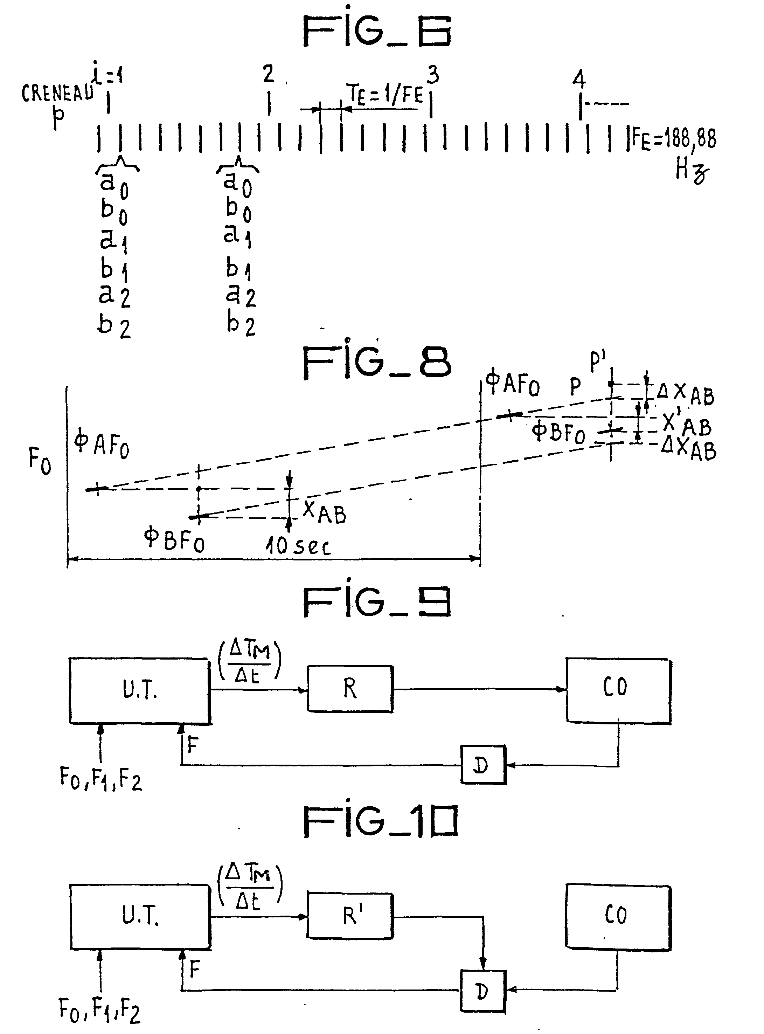

Selon la figure 5, en variante, on réalise deux mesures de phase pendant la zone utlie de 0,625 s en séparant celle-ci en deux zones de largeur 0,3 s environ, de manière à obtenir deux mesures $\Phi_1$ et $\Phi_2$ de la phase moyenne pour chaque fréquence. On montrera plus loin quel intérêt cela présente.

Le fonctionnement d'un récepteur OMEGA commence par une phase de synchronisation qui a pour but de centrer la réception sur les créneaux d'émission et de retrouver le début des formats OMEGA. Il est clair que toute boucle de synchronisation classique peut convenir dans le cadre de la présente invention. Dans la description qui va suivre toutefois, on va décrire une synchronisation particulière qu'il est avantageux d'utiliser avec le dispositif de compensation suivant l'invention.

L'horloge locale produit donc (voir figure 6) des impulsions à une fréquence d'échantillonnage $F_E$ de 188,88 Hz obtenue par division et qui a pour avantage d'être nominalement un sous-multiple commun des trois fréquences $F_0$, $F_1$ et $F_2$ (mais qui ne l'est bien entendu qu'à la précision de l'horloge locale près). Ce choix permet de simplifier le traitement des informations. Elle n'est par contre pas un sous-multiple des autres fréquences OMEGA, par exemple 11,05 KHz, ce qui permet de les éliminer par moyenne. L'échantillonnage correspond à des cycles successifs récurrents à la fréquence de 188,88 Hz, impliquant chacun 6 opérations élémentaires d'échantillonnage (voir également figure 7), la première pour mémoriser l'échantlilonnage $a_0$ de la fréquence $F_0$, la deuxième pour mémoriser l'échantillonnage $b_0$ de celle-ci en quadrature avec $a_0$, et ainsi de suite respectivement $a_1$ et $b_1$, et $a_2$ et $b_2$, pour les fréquences $F_1$ et $F_2$. Posons $T_0 = 1/F_0$, $T_1 = 1/F_1$ et $T_2 = 1/F_2$. Les filtres OMEGA étant commutés successivement sur les trois fréquences $F_0$, $F_1$ et $F_2$ avec une fréquence de $3F_E$, chaque échantillonnage $a_0$ a lieu au début de chaque période d'échantillonnage $T_E$, et est suivi d'un échantillonnage $b_0$ en quadrature, séparé de $a_0$ par $(0,25 + K_0) T_0$ avec $K_0$ entier positif ou nul. Quelque soit $K_0$, les conditions de l'échantillonnage ne sont pas modifiées. Chaque échantillonnage $a_1$ a lieu après l'échantillonnage $a_0$ précédent et est suivi d'un échantillonnage $b_1$ en quadrature, séparé de $a_1$ par $(0,25 + K_1)$ $T_1$ avec $K_1$ entier positif ou nul. Chaque échantillonnage $a_2$ a lieu après l'échantillonnage $a_1$ précédent et est suivi d'un échantillonnage $b_2$ en quadrature, séparé de $a_2$ par $(0,25 + K_2) T_2$ avec $K_2$ entier positif ou nul. D'autre part, $a_1$ est espacé de $b_0$ par un intervalle A, $a_2$ est espacé de $b_1$ par un intervalle B et le $a_0$ suivant est espacé de $b_2$ par un intervalle C. On choisit de préférence $K_0$, $K_1$, $K_2$, A, B et C de manière à répartir uniformément les échantillonnages dans l'intervalle $T_E = 1/F_E$. Sur la figure 7, on a choisi $K_0 = K_1 = 8$, $K_2 = 10$, A = 809µs, B = 729µs, C = 1467µs.

On détermine avec un pas de 25,6 Hz la variance normalisée.

Comme représenté figure 6, étant donné que 25,6 n'est pas un sous-multiple de 188,88, à chaque pas à la fréquence de 25,6 Hz correspondent 7 ou bien 8 échantillonnages à 188,88 Hz. Par contre, 32 pas à 25,6 Hz correspondent à un créneau OMEGA (1,25 s). Pour une $i^{ème}$ impulsion d'un signal à 25 6 Hz intervenant à l'instant t, la variance normalisée $r_i$ est calculée à partir des échantillonnages précédents pour les trois fréquences $F_j$, j variant de 0 à 2.

On pose alors:

$$r_i = \frac{\sum\limits_{t-625}^{t} \sum\limits_{j=0}^{j=2} (a_j^2 + b_j^2)}{\sum\limits_{t-625}^{t} \left(\sum\limits_{j=0}^{j=2} a_j\right)^2 + \sum\limits_{t-625}^{t} \left(\sum\limits_{j=0}^{j=2} b_j\right)^2}$$

Le numérateur est ainsi constitué de la somme des carrés de tous les échantillonnages $a_j$ et $b_j$ réalisés entre l'instant t-625 ms et l'instant t. Le dénominateur est constitué de la somme de deux termes. Le premier est la somme, élevée au carré, des résultats de tous les échantillonnages $a_j$ réalisés entre l'instant t-625 ms et l'instant t. Le second est la somme, élevée au carré, des résultats de tous les échantillonnages en quadrature $b_j$ réalisés entre l'instant t-625 ms et l'instant t.

Pour simplifier les calculs, la variance normalisée pourra être calculée à partir de totalisations partielles effectuées au pas de 25,6 Hz. Pour la $k^{ème}$ impulsion du signal à 25,6 Hz on posera:

$a_{kj} = a_j$ moyenné sur tous les échantillonnages réalisés depuis la $(k-1)^{ième}$ impulsion du signal à 25,6 Hz

$b_{kj} = b_j$ moyenné sur tous les échantillonnages réalisés depuis la $(k-1)^{ième}$ impulsion du signal à 25'6 Hz.

Il vient alors:

4

$$r'_i = \frac{\sum\limits_{k=i-16,j=0}^{k=i,\,j=2} (a_{kj}^2 + b_{kj}^2)}{\sum\limits_{k=i-16,j=0}^{k=i,\,j=2} a_{kj}^2 + \sum\limits_{k=i-16,\,j=0}^{k=i,\,j=2} b_{kj}^2}$$

Cette sommation a bien lieu sur 625 ms puisque c'est l'intervalle qui sépare 16 impulsions de cadence de répétition 25,6 Hz. En première approximation, pour des signaux non excessivement bruités, l'inverse $q_{ij}$ (ou bien $q'_{ij}$) de la variance normalisée respectivement $r_{ij}$ (ou bien $r'_{ij}$) est la qualité qui est d'autant plus élevée que les émissions reçues sont plus fortes. La variance est une grandeur physique immédiatement mesurable par la formule statistique indiquée ci-dessus. La qualité est par contre une grandeur sans signification physique qui est commode pour la recherche de synchronisation. Elle correspond, quoique de manière non mathématiquement rigoureuse, à un rapport signal/bruit. Elle peut par contre être définie autrement que par l'inverse de la variance, mais de telle sorte qu'un bruit aléatoire corresponde à une qualité nulle, et un signal à une fréquence multiple de la fréquence d'échantillonnage, à une qualité non nulle.

Cette qualité est calculée à partir donc des variances, à la même fréquence de 25,6 Hz et ses valeurs sont additionnées au pas de 1,25 s qui correspond au pas des émissions du format OMEGA. Un intervalle de 1,25 s correspond à un nombre entier 32 d'impulsions de 25,6 Hz. On effectue donc des sommations de qualité, modulo 1,25 s, de manière à rechercher la position des créneaux OMEGA qui est obtenue à partir du maximum de la qualité, en mettant ainsi à profit par sommation les trois fréquences $F_0$, $F_1$ et $F_2$ et l'ensemble des émetteurs qui peuvent être reçus. On notera que la mesure n'est pas perturbée par les émetteurs non reçus qui correspondent à un bruit aléatoire à ia réception et donc à une qualité nulle. Etant donné le mode de calcul mis en oeuvre ci-dessus, le maximum de qualité sera obtenu à la fin de la plage commune utile des émissions OMEGA, ce qui permet donc de positionner la plage de 625 ms utilisée pour la compensation d'horloge.

Lors de la mise en route du dispositif, on réalise les sommations sur un certain nombre de formats OMEGA de manière à avoir une statistique suffisante pour la synchronisation.

On remarquera que cette synchronisation n'est qu'un verrouillage grossier sur le format OMEGA, lequel est suffisant pour la compensation de dérive d'horloge, explicitée dans la suite de la description, mais n'est pas aussi élaborée que la synchronisation fine utilisée habituellement pour le traitement de l'information de position reçue par un récepteur OMEGA. La mise en oeuvre d'une telle procédure de synchronisation grossière apporte l'avantage d'une acquisition plus rapide que dans le cas d'une synchronisation fine.

La comparaison entre les phases des émissions OMEGA et celle de l'horloge à compenser est réalisée en utilisant les informations échantillonnées dans l'intervalle défini par 16 impulsions à la fréquence 25,6 Hz constituant la zone utile de 625 ms.

Cette mesure de phase est réalisée de préférence pour chacune des fréquences $F_0$, $F_1$ et $F_2$ et pour chacun des émetteurs reçus (en pratique 3 ou 4).

Comme on l'a dit précédemment (voir figure 4), on peut réaliser une moyenne unique sur chaque créneau OMEGA pour les fréquences reçues. Si on suppose par exemple (voir figure 3) que les fréquences $F_0$, $F_1$ et $F_2$ sont reçues à partir des émetteurs A, B et D, on calculera lors de leur apparition dans chaque format les phases $\Phi_{AF0}$, $\Phi_{AF1}$, $\Phi_{AF2}$, $\Phi_{BF0}$, $\Phi_{BF1}$, $\Phi_{BF2}$, $\Phi_{DF0}$, $\Phi_{DF1}$, $\Phi_{DF2}$. Pour expliciter la notation, $\Phi_{AF0}$ par exemple signifie la différence de phase exprimée en radians entre le signal $F_0$ émis par l'émetteur A et l'horloge locale telle qu'elle est mesurée par moyenne sur la zone utile de 650 ms du créneau correspondant. On a donc:

$$\Phi_{AF0} = \text{Arctg}\, \frac{b_0}{a_0}$$

moyenné pendant la durée de la zone utile d'un créneau d'un format OMEGA correspondant à l'émission de $F_0$ par l'émetteur A.

On en déduit le décalage temporel $T_{AF0} =$

$$\frac{1}{2\pi F_0}\, \Phi_{AF0}$$

Il en est bien entendu de même pour les autres phases.

On notera que dans le cadre du dispositif de compensation, il n'est pas nécessaire d'identifier en tant que tels les émetteurs A, B ou D, puisque leurs émissions ont une récurrence de 10 secondes.

Suivant la figure 5, on peut de manière avantageuse réaliser deux moyennes, l'une correspondant à la première moitié de la zone utile, et l'autre à la deuxième moitié de celle-ci. On obtiendra ainsi pour chaque format les 18 phases moyennées: $\Phi_{1AF0}$, $\Phi_{2AF0}$, $\Phi_{1AF1}$, $\Phi_{2AF1}$, $\Phi_{1AF2}$, $\Phi_{2AF2}$, $\Phi_{1BF0}$, $\Phi_{2BF0}$, $\Phi_{1BF1}$, $\Phi_{2BF1}$, $\Phi_{1BF2}$, $\Phi_{2BF2}$, $\Phi_{1DF0}$, $\Phi_{2DF0}$, $\Phi_{1DF1}$, $\Phi_{2DF1}$, $\Phi_{1DF2}$, $\Phi_{2DF2}$.

$\Phi_{1AF0}$ est la différence de phase entre le signal $F_0$ émis par l'émetteur A et l'horloge locale telle qu'elle est mesurée par moyenne sur la première moitié de la zone utile du créneau correspondant. Donc:

$$\Phi_{1AF0} = \text{Arctg} \ \frac{b_o}{a_o}$$

moyenné pendant la première moitié de la zone utile d'un créneau d'un format OMEGA correspondant à l'émission de $F_0$ par l'émetteur A. On aura également $T_{1AFo} =$

$$\frac{1}{2\pi F_o}$$

Cette double mesure de phase dans un créneau OMEGA presente l'avantage d'améliorer la résolution du système, c'est-à-dire qu'une extrapolation linéaire correcte peut être obtenue à l'aide d'un calcul de prédiction tant que $\Phi_2-\Phi_1$ correspond à une rotation de phase pouvant aller jusqu'à $2\pi$ pendant 0,3 s. L'intérêt d'une telle extrapolation apparaîtra mieux dans la suite de la description.

Par référence à la figure 8, on va indiquer comment on peut avantageusement traiter ensemble les différentes mesures de décalage temporel obtenues à partir des émetteurs A, B et D pour la fréquence $F_0$.

La variation de $\Phi_{AFo}$ ou de $T_{AFo}$ entre deux formats successifs est assimilable à une droite, du fait que les dérives de l'horloge locale sont très lentes et que l'on est bien entendu dans des conditions où l'effet Doppler est négligeable. Il en est de même pour la variation de $\Phi_{BFo}$ ou de $T_{BFo}$. Comme A et B sont deux stations qui émettent en des lieux très éloignés l'une de l'autre, le mobile qui les reçoit les détecte avec une phase relative, donc un décalage relatif qui est fonction de sa position. C'est pourquoi les droites qui joignent les phases $\Phi_{AFo}$ ou les décalages temporels $T_{AFo}$ et les phases $\Phi_{BFo}$ ou les décalages temporels $T_{BFo}$ des formats successifs sont dans le cas général parallèles, mais non confondues.

Soit $T_{BA} = T_{AFo}-T_{BFo}$ pour le premier format représenté à la figure 8, et $T'_{BA} = T_{AFo}-T_{BFo}$ pour le format suivant. On aura:

$\Delta T_{BA} = T'_{BA} - T_{BA}$ (décalages temporels) ou $\Delta X_{AB} = X'_{AB} - X_{AB}$ (décalages de phases).

Comme une mesure donnée de $T_{AFo}$ est affectée par le bruit, l'extrapolation linéaire ne conduit pas forcément à un $\Delta T_{BA}$ nul, c'est-à-dire que le point P correspondant à cette extrapolation au niveau du créneau où l'émetteur B émet $F_0$ doit être corrigé de $\Delta T_{BA}$ pour devenir un oint P' qui correspond ainsi à une mesure de phase directement exploitable, ce qui permet de compenser le décalage relatif entre les émissions reçues des émetteurs A et B. Il en va bien entendu de même pour l'émetteur D. On réitère pour chaque format cette opération, ce qui donne une succession de points de mesure ramenés à l'émetteur A qui sert d'émetteur de référence. On choisira avantageusement comme émetteur de reference celui qui est le mieux reçu, à savoir le plus proche du lieu où se trouve le mobile. On effectue avantageusement ces opérations, avec de préférence le même émetteur comme référence, également pour les fréquences $F_1$ et $F_2$, ce qui permet d'accumuler le maximum de statistique. Il va de soi qu'un traitement similaire peut être réalisé à partir des décalages $T_1$ et $T_2$ (figure 5).

Lors de la mise en service du dispositif, on réalise pendant un temps donné, par exemple 5 minutes, un filtrage par moyenne des pentes de phase, par exemple en traitant les mesures de phases décalages temporels T relatives à $F_0$, $F_1$ et $F_2$, corrigées par rapport à un émetteur de référence, par la méthode des moindres carrés pour obtenir des valeurs de pente moyenne de décalage par rapport au temps t, correspondant à la précision de l'horloge locale à corriger. La dérive de l'horloge locale à corriger doit pendant ce temps être négligeable. Comme on l'a dit plus haut, les horloges à quartz de qualité courante présentent des dérives d'origine essentiellement thermique, donc lentes. Des dérives rapides ne se produisent en pratique que lorsque l'alimentation du quartz est défectueuse. Il faut donc utiliser une horloge pourvue d'une alimentation correctement stabilisée. On obtient donc trois pentes moyennes calculées pour $F_0$, $F_1$ et $F_2$, respectivement

$$\left(\frac{\Delta\,TM}{\Delta t}\right)_{F_0}, \left(\frac{\Delta\,\dot{TM}}{\Delta t}\right)_{F_1}, \left(\frac{\Delta\,TM}{\Delta t}\right)_{F_2}.$$

On calculera, afin de tenir compte de la statistique accumulée sur les trois fréquences $F_0$, $F_1$ et $F_2$, une pente moyenne cumulée, à savoir:

$$\left(\frac{\Delta TM}{\Delta t}\right)_{F_0, F_1, F_2} = \frac{\left(\frac{\Delta\,TM}{\Delta t}\right)_{F_0} + \left(\frac{\Delta\,TM}{\Delta t}\right)_{F_1} + \left(\frac{\Delta\,TM}{\Delta t}\right)_{F_2}}{3}$$

Cette pente, calculée au départ, est utilisée pour appliquer une correction de départ à l'horloge locale. Son calcul sera poursuivi à des intervalles donnés pour réaliser la compensation des dérives.

Selon un premier mode de réalisation représenté à la figure 9, l'horloge locale est corrigée par action sur une tension de commande, par exemple de manière connue en soi à l'aide d'une capacité commandée en tension (Varicap). Une unité de traitement U.T. reçoit les fréquences $F_0$, $F_1$ et $F_2$ ainsi que la fréquence Fde l'oscillateur à compenser, après division par un diviseur D selon un rapport n et produit à sa sortie un signal

$$\frac{\Delta\,T}{\Delta\,t}$$

introduit dans un régulateur analogique R à action intégrale. Ce régulateur pilote la tension de commande du quartz du circuit CO de commande d'oscillateur. Lors de la mise en service, c'est donc le signal

$$\left(\frac{\Delta TM}{\Delta\,t}\right)$$

$F_0$, $F_1$, $F_2$ qui est introduit à l'entrée du regulateur R. Le signal

$$\left(\frac{\Delta\,TM}{\Delta\,t}\right)$$

$F_0$, $F_1$, $F_2$ est ensuite périodiquement remplacé par des signaux élaborés dans des conditions analogues, par exemple la statistique cumulée pendant les cinq minutes précédentes. A des intervalles donnés, le régulateur R reçoit à son entrée

$$\frac{\Delta\,TM}{\Delta\,t}\ \text{corres-}$$

correspondant à une pente moyenne cumulée pendant un temps donné, par exemple les cinq demières minutes. Pendant toute la durée d'un intervalle, le régulateur R reçoit la même valeur.

Selon un mode de réalisation préféré représenté à la figure 10, l'horloge locale est corrigée par action sur les impulsions qu'elle délivre. pour ce faire, l'unité de traitement U.T. délivre, dans les mêmes conditions que pour le mode de réalisation de la figure 8, les signaux

$$\frac{\Delta TM}{\Delta t} \text{, cette}$$

cette fois à un régulateur numérique R' à action intégrale. Le régulateur R' va intégrer

$$\frac{\Delta TM}{\Delta t}$$

jusqu'à ce que cette valeur corresponde à un déphasage de $\Delta \zeta$ pour une fréquence choisie, par exemple $F_0$. Le regulateur R' agit alors sur le circuit de division D qui divise selon un rapport de division n les signaux d'horloge délivrés par le circuit CO de commande d'horloge, de manière à modifier pour un cycle son rapport de division, c'est-à-dire qu'il devient n-1 ou n+1 suivant le sens de la variation de phase. Supposons que le quartz utilisé ait une fréquence propre nominale de 1,8888 MHz et que le rapport de division n soit égal à 1000, pour produire l'échantillonnage à 188,88 Hz. Lorsque le

$$\left(\frac{\Delta T}{\Delta t}\right)$$

$F_0$ intégré aura atteint une valeur correspondant à une variation de phase $\Delta \zeta$ donnée pour la fréquence $F_0$, c'est-à-dire que la fréquence $F_0$ aura acquis une avance temporelle de $\Delta\zeta/F_0$ par rapport à l'horloge locale, le rapport de division du diviseur D sera, pour une seule opération de division, établi à une valeur égale à n-1 = 9999 de manière à recaler l'horloge locale. Dans le cas d'un retard, on prendra n+1 = 10.001.

La compensation est alors obtenue (voir figure 7) en modulant l'un des intervalles A, B ou C, et de préférence l'intervalle C. En l'absence de correction à appliquer, cet intervalle vaut un nombre donné d'impulsions de l'horloge locale, dans l'exemple donné, 2771 correspondant à 1467 µs. Ce nombre sera incrémenté d'une unité en plus ou en moins suivant la correction à appliquer, à savoir dans l'exemple donné 2770 ou 2772. La mesure des phases des stations issues également des échantillonnages en phase et en quadrature de l'horloge locale, n'est pas sensible aux corrections très faibles ($\pm$ $10^{-5}$) introduites statistiquement.

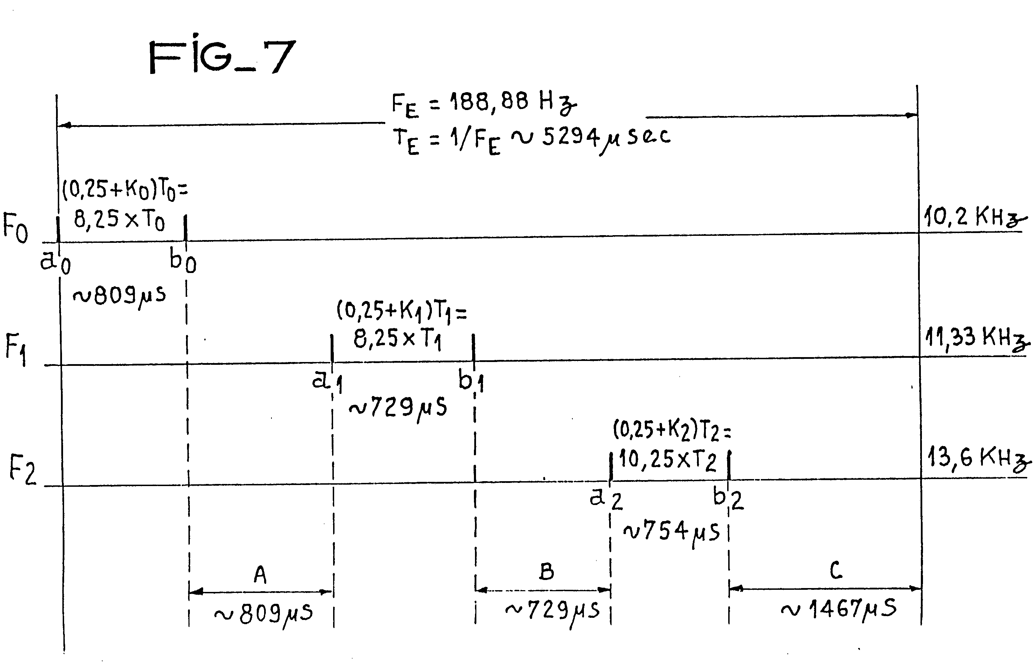

La figure 11 décrit un mode de réalisation de l'invention suivant la variante de la figure 9. Un circuit de réception $\Omega$ reçoit les signaux des émissions OMEGA et les introduit dans un circuit CF de commutation de filtres OMEGA aux fréquences $F_0$, $F_1$ et $F_2$. Un circuit CAG de contrôle automatique de gain transmet les fréquences reçues à un circuit d'échantillonnage CE dont les signaux, numérisés par un convertisseur analogique-numérique NUM, sont introduits dans un micro-processeur µP. Le micro-processeur µP envoie des ordres d'échantillonnage à une base de temps BT qui reçoit les impulsions du circuit CO de commande d'oscillateur et produit vers le circuit d'échantillonnage CE des couples d'impulsions destinées aux échantillonnages $a_0$, $b_0$, $a_1$ $b_1$ $a_2$ et $b_2$. Le rapport de division qu'applique la base de temps BT aux impulsions périodiques est commandé par les ordres du micro-processeur qui effectue en temps réel les calculs de synchronisation sur les formats ainsi que les calculs de phase suivant la procédure décrite plus haut en détail.

Un dispositif selon la figure 11 ne constitue un dispositif de radio-navigation OMEGA que dans la mesure où le micro-processeur µP effectue également les calculs de localisation proprement dits.

Lorsque la boucle de phase permettant de corriger l'horloge locale est verrouillée depuis un temps assez long et que les émissions OMEGA sont reçues dans des conditions normales, l'horloge locale corrigée a une précision qui tend vers celle des émissions OMEGA aux phénomènes de propagation près, à savoir $10^{-9}$-$10^{-8}$.

D'autre part, la compensation statistique de l'horloge (figures 10 et 11) ne présente pas d'inconvénient pour le traitement des signaux OMEGA en vue de la détermination de la position du mobile, car cette approximation correspond à un bruit de phase en pratique assez faible et qui n'obère donc pas la précision de cette détermination.

Le dispositif de compensation décrit ci-dessus n'est qu'une approximation. En effet, les déplacements du mobile introduisent des variations au niveau de la phase des émissions reçues, la phase relative entre ces émissions étant utilisée pour calculer la position du mobile. Il en résulte que l'horloge locale est compensée quant à sa fréquence, mais non quant à sa phase. Il est à noter que, dans la reconstitution de la position du mobile dans le cadre du système OMEGA, l'horloge locale doit être stable en fréquence (typiquement meilleure que $10^{-6}$), mais elle n'a pas besoin d'être verrouillée en phase. Le dispositif de compensation décrit ci-dessus est donc satisfaisant pour ce genre d'utilisation.

Selon un mode de réalisation plus élaboré, on tient compte de la position du mobile pour la compensation de l'horloge locale. L'architecture générale de cette opération est la suivante:

- on réalise une première compensation de l'horloge locale comme on l'a décrit plus haut, ce qui permet de calculer les phases relatives entre les émissions de même fréquence et la position du mobile;
- on utilise les informations de phase ainsi calculées pour verrouiller en phase l'horloge locale, ce qui permet dans tous les cas d'assurer à cëlle-ci après convergence des algorithmes, une stabilité comparable à celle de l'horloge du temps universel, au Doppler et aux irrégularités de propagation près.

On va maintenant décrire plus en détail une telle opération:

Soit $X_k^j$ (t) le nombre de cycles reçus par le dispositif depuis la station k pour la fréquence $F_j$, entre sa mise en service et l'instant t, k variant de 1 à 8 et correspondant aux stations A à H dans le système OMEGA.

Soit $S_k^j$ (t) le nombre de cycles émis par la station k pour la fréquence $F_j$ entre la mise en service du dispositif et l'instant t.

Soit $\lambda_j$ la longueur d'onde d'un signal de fréquence $F_j$.

Soit $\zeta_k$ la distance du mobile à la station A.

Il vient:

$$S_k^j(t) = X_k^j(t) + \frac{\rho_k}{\lambda_j}$$

(le nombre de cycles émis est égal au nombre de cycles reçus auquel s'ajoute le nombre de cycles sur le trajet 1).

On en déduit le temps absolu:

$$T = \frac{S_k^j(t)}{F_j} = \frac{X_k^j(t)}{F_j} + \frac{\rho_k}{c}$$

La première étape est le comptage des cycles reçus.

Soit E(x) la partie entière de x.

Soit R(x) = x - E(x) la partie fractionnaire de x.

On pose:

$$\zeta(x) = (x)^{\cdot} = R(x - \tfrac{1}{2}) - \tfrac{1}{2}.$$

Quelque soit x réel, on aura F(x) ε

$$\left[ -\tfrac{1}{2}, \tfrac{1}{2} \right[$$

On a également F(n) = 0 quelque soit n entier.

$\zeta$ (x) sera dénommé phase résiduelle de x. L'utilisation d'une telle phase résiduelle variant entre

$$-\tfrac{1}{2} \text{ et } + \tfrac{1}{2}$$

est de nature, par sa symétrie, à simplifier les opérations de calcul. On pourrait bien entendu choisir une autre fonction représentative, puisque les calculs d'itération se font sur des différences.

Pour un échantillonnage donné, de la fréquence Aj, on aura:

$$\zeta_k^j = \frac{1}{2\pi} \rho_{kF_j} - \tfrac{1}{2} \qquad \text{avec } k = A, B \ldots H$$
$$j = 0, 1, 2$$

On pose:

$$\zeta_{kk'}^j = \zeta_{k'}^j - \zeta_k^j$$

$$X^j_{kk'} = X^j_{k'} - X^j_k$$

En outre: $\zeta_k^j(p)$ et $X_k^j(p)$ correspondent aux résultats des échantillonages réalisés pour le p[ième] format OMEGA.

On tient à jour toutes les 10 secondes pour toutes les stations k et pour la fréquence Fj, le nombre $X^j_{gk}$ de cycles reçus des stations par rapport à une station barycentrique fictive g. Cette récurrence ne fait pas intervenir l'horloge locale. Soit $r_k^j$ s et $\alpha_k^j$ respectivement la variance et la qualité de l'émission reçue de la station k pour la fréquence $F_j$ et cumulée sur le créneau correspondant du p[ième] format OMEGA.

Pour le p[ième] format OMEGA, on aura:

$$X^j_{gk}(p) = X^j_{gk}(p-1) + \sum_{k' \neq k} \alpha^j_{k'}(p) \mathcal{F} \left\{ \zeta^j_{kk'}(p) - X^j_{kk'}(p-1) \right\}$$

Au Doppler et aux irrégularités de propagation près, on a:
$X_{kk'}^j(p-1) = \zeta_{kk'}^j(p-1)$.
Le terme $X^j_g(p)$ correspondant au nombre de cycle reçu par la station barycentrique fictive ne peut être obtenu valablement que lorsque la fréquence de l'horloge H est connue.
On aura

$$X^j_g(p) = X^j_g(p-1) + \frac{F_j}{H}\left(s(p) - s(p-1)\right) + \alpha^j(p)\,\mathcal{E}^j_i$$
$$\text{avec } \alpha^j(p) = \sum_k \alpha^j_k(p)$$

et $s(p) = $ nombre de cycles du quartz local de fréquence H à un moment choisi du p[ième] format OMEGA. Ce moment choisi est quelconque dans le format OMEGA, mais ne varie pas d'un format à l'autre. Il est obtenu à partir de l'horloge locale corrigée en fréquence. D'autre part, $\alpha^j$ sert de coefficient de pondération pour rendre la convergence plus lente, mais plus sûre.

On a d'autre part:

$$\mathcal{E}^j_i = \sum_k \alpha^j_k \mathcal{F}\left\{ X^j_{gk}(p) + X_g(p-1) + \frac{F_j}{H}\left(s(p) - s(p-1)\right) - \varphi^j_k \right\}$$

Pour chaque format OMEGA, la suite des opérations de traitement est donc imbriquée de la manière suivante:
a) acquisition d'échantillons des signaux
b) calcul des $\varphi_k^j$ et des $r_k^j$
c) calcul des $d\varphi_k^j/dt$, et calcul des $\alpha_k^j$ et des $\alpha^j$ à partir des $r_k^j$
d) calcul de $X_{g_k}$
e) calcul de H et de $X_g$
f) calcul du temps absolu T
L'exemple d'algorithme donné ci-dessus est bien entendu un mode de calcul particulier qui a pour avantage de définir la station barycentrique fictive en faisant intervenir les qualités des différentes émissions reçues à partir des différentes fréquences et des différentes stations. Il est clair que le mode de pondération utilisé pourrait être différent. Ainsi, on peut prendre par convention tous les $\alpha_k^j(p)$ égaux à 1, ou bien les choisir inférieurs à 1, mais en les pondérant par des facteurs en $1/\zeta_k$, qui peuvent n'évoluer que tous les n formats OMEGA.

Dans le cas d'une pondération fixée une fois pour toute, la suite des opérations de traitement est alors sensiblement plus courte:
a) acquisition des échantillons des signaux
b) calcul des $\varphi_k^j$
c) calcul des $d\,\varphi_k^j/dt$
d) calcul de $X_k^{ij}$
e) calcul de H et de $X_g$
f) calcul du temps absolu T.

De la même façon, l'opération de traitement qui conduit au calcul du temps absolu et qui va être maintenant explicitée fait intervenir, dans les mêmes conditions que précédemment, une pondération. Pour les mêmes raisons, cette pondération est exemplifiée sous une forme préférée tenant compte de la qualité des émissions reçues à partir des différentes fréquences et des différentes stations.

Le calcul du temps T peut être réalisé à partir d'une seule fréquence j. Pour le $p^{ième}$ format OMEGA, il vient:

$$T_j(p) = T_j(p-1) + \frac{s(p) - s(p-1)}{H} + \alpha^j \mathcal{E}_2^j$$

avec

$$\alpha_2^j = \sum_k \alpha_k^j \, F \left\{ X_{gk}^j(p) + F_j \left( T_j(p-1) + \frac{s(p) - s(p-1)}{H} \right) - \zeta_k^j \right\}$$

On réalisera de préférence le calcul du temps en se servant des trois fréquences $F_0$, $F_1$, $F_2$ par exemple par moyenne.

On peut également définir un temps dit barycentrique Tg(p) qui tienne compte de la qualité. Ce temps sera défini par l'itération suivante:

$$Tg(p) = Tg(p-1) + \frac{s(p) - s(p-1)}{H} + \alpha \sum_j \frac{\mathcal{E}_3^j}{F_j}$$

avec $\alpha = \sum_j \alpha^j$ et

$$\mathcal{E}_3^j = \sum_k \alpha_k^j \, F \left\{ X_{gk}^j(p) + F_j \left( T_g(p-1) + \frac{s(p) - s(p-1)}{H} \right) - \zeta_k^j \right\}$$

On en déduit le temps absolu T par la formule suivante qui est valable quelque soit j et k

$$T(p) = Tg(p) + \frac{X_{gk}^j}{F_j} - \frac{\zeta_k}{c}$$

avec $\zeta_k$ = distance du mobile à la source k, telle que calculée par le dispositif de radio-navigation. Le temps absolu permet comme on l'a fait pour la fréquence, de recaler la phase de l'horloge locale pour la synchroniser avec le temps absolu calculé.

Il apparaîtra clairement à l'homme du métier que les formules d'itération convergentes données ci-dessus donnent des résultats qui sont liés aux conditions d'initialisation choisies au départ. Pour le format OMEGA référencé 0 par convention, on peut par exemple prendre, quelque soit k et j:
$X_k^j = 0 \; \alpha_k^j = 1 \; s(o) = 0$
En plus du fait que l'horloge locale corrigée est utilisable dans le cadre du système de radio-navigation, par exemple OMEGA, dont les signaux ont contribué à la corriger, celle-ci peut être également utilisée pour le décodage d'autres émissions de radio-navigation dans le cadre d'un dispositif de radio-navigation combiné, par exemple OMEGA et LORAN C. En particulier, le système LORAN C exige une horloge locale de grande précision que le dispositif de compensation suivant l'invention est à même de fournir.

L'horloge locale corrigée suivant l'invention peut également servi d'horloge de référence pour des récepteurs de radio-navigation par satellite en particulier du système TRANSIT ou NAVSTAR/GPS.

**Revendications**

1. Procédé de compensation d'une horloge locale consistant à:
- recevoir au moyen d'un circuit de réception (2) au moins une émission, ($F_0$, $F_1$ ou $F_2$) sous forme de créneaux d'au moins un émetteur piloté par une horloge de haute précision;
- produire au moyen d'un circuit de synchronisation (4) une synchronisation au moins approximative sur les créneaux d'émission dudit émetteur;
- échantillonner au moyen d'un circuit de comparaison (1) ladite émission à une fréquence d'échantillonnage ($F_E$) sous-multiple de la fréquence (F) de l'horloge locale (3) et en déduire une comparaison entre la fréquence de l'horloge locale et cette de ladite émission;
- corriger au moyen d'un circuit de correction (5) la fréquence de l'horloge locale (3), en fonction du résultat de ladite comparaison,
procédé dans lequel la fréquence d'échantillonnage ($F_E$) est définie par division de celle de l'horloge et égale nominalement à celle de ladite émission ou à un sous-multiple de celle-ci, dans lequel plusieurs émissions de fréquence différente sont reçues sous forme de créneaux d'au moins un émetteur et dans lequel ladite fréquence d'échantillonnage ($F_E$) est un sous multiple commun desdites fréquences d'émission ($F_0$, $F_1$, $F_2$), caractérisé en ce qu'à l'issue de l'opération d'échantillonnage sont obtenus des couples d'impulsions ($a_0$, $b_0$; $a_1$, $b_1$; $a_2$, $b_2$) dont la récurrence correspond à ladite fréquence d'échantillonnage ($F_E$), afin de produire un échantillonnage ($a_0$, $a_1$, $a_2$) et un échantillonnage en quadrature ($b_0$, $b_1$, $b_2$) pour une fréquence donnée (respectivement $F_0$, $F_1$ ou $F_2$), et en ce que le décalage temporel entre ladite fréquence d'échantillonnage ($F_E$) et au moins une fréquence d'au moins une émission ($F_0$, $F_1$ ou $F_2$) est calculé périodiquement.

2. Procédé selon la revendication 1, caractérisé en ce que le circuit de comparaison (1) est agencé de manière à produire au moins un calcul de pente de décalage temporel moyenné sur une durée donnée pour au moins une fréquence donnée et un émetteur donné.

3. Procédé selon la revendication 1, caractérisé en ce que le circuit de réception (2) est agencé pour recevoir les émissions du système OMEGA et en ce que le circuit de comparaison (1) est agencé pour effectuer lesdits calculs sur les plages utiles d'emission des créneaux des formats OMEGA.

4. Procédé selon la revendication 3, caractérisé en ce que le circuit de comparaison (1) est agencé de manière à produire au moins un calcul de pente de décalage temporel moyenné sur une durée donnée pour une fréquence donnée et plusieurs émetteurs par compensation des décalages relatifs entre les émissions reçues des différents émetteurs.

5. Procédé selon la revendication 4, caractérisé en ce que le circuit de comparaison (1) est agencé de manière à produire plusieurs dits calculs de pente de décalage temporel moyennés sur une durée donnée, chacune pour une fréquence donnée et plusieurs émetteurs, et à calculer la moyenne desdites pentes, ceci constituant ladite comparaison.

6. Procédé selon l'une des revendications 3 à 5, caractérisé en ce que la synchronisation est assurée par calcul avec un pas donné de la qualité sommée sur un intervalle précédent de l'ordre de 625 ms et cumulée modulo 1,25 s, et par détermination de l'instant où ladite qualité cumulée est maximale, de manière à produire la synchronisation sur lesdites plages utiles.

7. Dispositif de compensation pour la mise en oeuvre du procédé selon l'une des revendications précédentes, caractérisé en ce que la correction est assurée par un circuit de correction (5) comportant un régulateur (R) à action intégrale recevant un signal du circuit de comparaison et agissant sur la tension de commande d'un circuit de commande (CO) de l'horloge à compenser (3).

8. Dispositif de compensation pour la mise en oeuvre du procédé selon l'une des revendications 2 à 6, caractérisé en ce que ladite comparaison est assurée par un circuit de comparaison (1) qui reçoit les signaux d'un circuit d'échantillonnage (CE) après numérisation (NUM), en ce que le circuit d'échantillonnage (CE) reçoit des signaux (F) d'une base de temps (BT) qui divise dans un rapport donné les impulsions de l'horloge à compenser (CO), et en ce que le circuit de comparaison est agencé pour modifier le rapport de division de la base de temps de manière à compenser ledit décalage.

9. Dispositif de radio-navigation destiné à déterminer la position d'un mobile, caractérisé en ce qu'il comporte un dispositif de compensation selon l'une des revendications précédentes.

10. Procédé selon l'une des revendication 1 à 6, mis en oeuvre dans un dispositif de radio-navigation destiné à déterminer la position d'un mobile, caractérisé en ce que la correction de la fréquence de l'horloge locale est assurée par calcul périodique par récurrence du temps absolu (T) écoulé depuis une origine donnée, à partir de calculs des phases relatives entre des émissions d'au moins une fréquence provenant de stations différentes et de la fréquence de l'horloge locale, et par compensation en conséquence de la phase de l'horloge locale compensée en fréquence.

11. Procédé selon la revendication 10, caractérisé en ce que le calcul périodique du temps absolu est réalisé selon les opérations suivantes imbriquées avec la correction en fréquence de l'horloge locale pour au moins une fréquence et plusieurs stations:

a) acquisition d'échantillons des signaux reçus,

b) calcul des phases ($\gamma_k j$) des signaux reçus par rapport à l'horloge locale compensée,

c) calcul des pentes de phase des signaux reçus ($d\gamma_k j/dt$),

d) calcul du nombre de cycles reçus des stations par rapport à une station barycentrique fictive ($X_k j$),

e) calcul de la fréquence (H) de l'horloge locale locale et du nombre de cycle de la station barycentrique ($X_g j$)

f) calcul du temps absolu (T).

12. Procédé selon l'une des revendications 10 ou 1 1, caractérisé en ce que la correction est assurée par ledit calcul périodique du temps absolu avec pondération desdites phases des émissions d'une même fréquence ($F_j$) provenant de stations différentes (k).

13. Procédé selon la revendication 11, caractérisé en ce que ladite pondération fait intervenir la qualité des émissions reçues.

14. Procédé selon les revendications 11 à 13 prises ensemble, caractérisé en ce que:

- l'étape b) comporte également pour au moins une fréquence donnée le calcul des variances ($r_k j$) des émissions correspondant chacune à une fréquence ($F_j$) des différents émetteurs (k) moyennée sur le créneau correspondant,

- l'étape c) comporte également le calcul des qualités ($\alpha_k j$) correspondant auxdites variances ($r_k j$) ainsi que la somme ($\alpha j$) sur les différents émetteurs (k) des variances ($\alpha_k j$) correspondant à une fréquence ($F_j$) de manière à réaliser ladite pondération.


## Patentansprüche

1. Kompensationsverfahren für eine lokale Uhr, darin bestehend, daß:

- mittels einer Empfangsschaltung (2) wenigstens eine Aussendung ($F_0$, $F_1$ oder $F_2$) in Form von Rechtecksignalen von wenigstens einem Sender empfangen wird, der durch eine hochpräzise Uhr gesteuert wird;

- mittels einer Synchronisationsschaltung (4) eine wenigstens angenäherte Synchronisation mit den gesendeten Rechtecksignalen des genannten Senders vorgenommen wird;

- mittels einer Komparatorschaltung (1) die genannte Aussendung mit einer Abtastfrequenz ($F_E$) abgetastet wird, die ein ganzzahliger Teiler der Frequenz (F) der lokalen Uhr (3) ist, und daraus ein Vergleich zwischen der Frequenz der lokalen Uhr und der Frequenz der genannten Aussendung abgeleitet wird;

- mittels einer Korrekturschaltung (5) die Frequenz der lokalen Uhr (3) in Abhängigkeit vom Ergebnis des genannten Vergleiches korrigiert wird,

wobei in diesem Verfahren die Abtastfrequenz ($F_E$) durch Division der Frequenz der Uhr definiert und nominell gleich der der genannten Aussendung oder einem ganzzahligen Teiler derselben ist, worin mehrere Aussendungen verschiedener Frequenz in Form von Rechtecksignalen von wenigstens einem Sender empfangen werden und worin die genannte Abtastfrequenz ($F_E$) ein ganzzahliger gemeinsamer Teiler der genannten Sendefrequenzen ($F_0$, $F_1$, $F_2$) ist, dadurch gekennzeichnet, daß am Ende des Abtastvorganges Impulspaare ($a_0$, $b_0$; $a_1$, $b_1$; $a_2$, $b_2$) erhalten werden, deren Wiederholungsfrequenz der genannten Abtastfrequenz ($F_E$) entspricht, um eine Abtastung ($a_0$, $a_1$, $a_2$) und eine um 90° phasenverschobene Abtastung ($b_0$, $b_1$, $b_2$) für eine gegebene Frequenz ($F_0$ bzw. $F_1$ bzw. $F_2$) zu erzeugen, und daß die Zeitverschiebung zwischen der genannten Abtastfrequenz ($F_E$) und wenigstens einer Frequenz wenigstens einer Aussendung ($F_0$, $F_1$ oder $F_2$) periodisch berechnet wird.

2. Verfahren nach Anspruch 1, dadurch gekennzeichnet, daß die Komparatorschaltung (1) derart ausgebildet ist, daß sie wenigstens eine Berechnung der Steilheit der mittleren Zeitverschiebung über eine gegebene Dauer für wenigstens eine gegebene Freguenz und einen gegebenen Sender erzeugt.

3. Verfahren nach Anspruch 1, dadurch gekennzeichnet, daß die Empfangsschaltung (2) ausgebildet ist, um Aussendungen des OMEGA-Systems zu empfangen und daß die Komparatorschaltung (1) ausgebildet ist, um die genannten Berechnungen über die nutzbaren Sendebereiche der Rechtecksignale der OMEGA-Formate durchzuführen.

4. Verfahren nach Anspruch 3, dadurch gekennzeichnet, daß die Komparatorschaltung (1) derart ausgebildet ist, daß sie wenigstens eine Berechnung der Steilheit der mittleren Zeitverschiebung über eine gegebene Dauer für eine gegebene Frequenz und mehrere Sender durch Vergleichen der relativen Verschiebungen zwischen den von den verschiedenen Sendern empfangenen Aussendungen erzeugt.

5. Verfahren nach Anspruch 4, dadurch gekennzeichnet, daß die Komparatorschaltung (1) derart ausgelegt ist, daß sie mehrere der genannten Berechnungen der Zeitverschiebungssteilheit über eine gegebene Dauer gemittelt erzeugt, jeweils für eine gegebene Frequenz und mehrere Sender, und den Mittelwert der genannten Steilheiten zu berechnen, was den genannten Vergleich bildet.

6. Verfahren nach einem der Ansprüche 3 bis 5, dadurch gekennzeichnet, daß die Synchronisation gewährleistet wird durch die mit einem gegebenen Teilungsschritt erfolgende Berechnung der über ein vorausgehendes Intervall der Größenordnung von 625 ms aufsummierten Qualität, kumuliert modulo 1,25 s, sowie durch Bestimmung desjenigen Zeitpunktes, wo die genannte kumulierte Qualität maximal ist, um die Synchronisation über die genannten nutzbaren Bereiche herbeizuführen.

7. Kompensationsvorrichtung für die Durchführung des Verfahrens nach einem der vorstehenden Ansprüche, dadurch gekennzeichnet, daß die Korrektur gewährleistet wird durch eine Korrekturschaltung (5), die einen Regler (R) mit Integralwirkung umfaßt, welcher ein Signal aus der Komparatorschaltung empfängt und auf die Steuerspannung einer Steuerschaltung (CO) der zu kompensierenden Uhr (3) einwirkt.

8. Kompensationsvorrichtung zur Durchführung des Verfahrens nach einem der Ansprüche 2 bis 6, dadurch gekennzeichnet, daß der genannte Vergleich gewährleistet wird durch eine Komparatorschaltung (1), welche die Signale von einer Abtastschaltung (CE) nach Digitalisierung (NUM) empfängt, daß die Abtastschaltung (CE) Signale (F) von einer Zeitbasis (BT) empfängt, welche die zu kompensierenden Impulse der Uhr (CO) in einem gegebenen Verhältnis teilt, und daß die Komparatorschaltung ausgelegt ist, um das Teilerverhältnis der Zeitbasis so zu verändern, daß die genannte Verschiebung kompensiert wird.

9. Funknavigationsvorrichtung zur Bestimmung der position eines bewegten Objektes, dadurch gekennzeichnet, daß sie eine Kompensationsvorrichtung nach einem der vorstehenden Ansprüche enthält.

10. Verfahren nach einem der Ansprüche 1 bis 6, angewendet bei einer Funknavigationsvorrichtung zur Bestimmung der position eines bewegten Objektes, dadurch gekennzeichnet, daß die Korrektur der Frequenz der lokalen Uhr gewährleistet wird durch die periodische Berechnung, pro Wiederholungsperiode, der absoluten Zeit (T), die ab einem gegebenen Ursprung verstrichen ist, aus den Berechnungen der relativen phasen zwischen den Aussendungen wenigstens einer Frequenz von verschiedenen Stationen und der Frequenz der lokalen Uhr, und folglich durch Kompensation der phase der lokalen frequenzkompensierten Uhr.

11. Verfahren nach Anspruch 10, dadurch gekennzeichnet, daß die periodische Berechnung der absoluten Zeit durch folgende Operationen erfolgt, die mit der Frequenzkorrektur der lokalen Uhr für wenigstens eine Frequenz und mehrere Stationen verschachtelt sind:

a) Erfassung von Abtastproben der empfangenen Signale, in bezug auf die kompensierte lokale Uhr,

c) Berechnung der Phasensteilheiten der empfangenen Signale $(d\Phi^J_k/dt)$,

d) Berechnung der Anzahl von aus den Stationen empfangenen Zyklen in bezug auf eine fiktive Schwerpunktstation $(X^J_k)$,

e) Berechnung der Frequenz (H) der lokalen Uhr und der Anzahl von Zyklen der Schwerpunktstation $(X^J)$,

f) Berechnung der absoluten Zeit (T).

12. Verfahren nach Anspruch 10 oder 11, dadurch gekennzeichnet, daß die Korrektur durch die genannte periodische Berechnung der absoluten Zeit gewährleistet wird, mit Wichtung der genannten Phasen der Aussendungen einer selben Frequenz $(F_j)$ aus verschiedenen Stationen (k).

13. Verfahren nach Anspruch 11, dadurch gekennzeichnet, daß bei der genannten Wichtung die Qualität der empfangenen Aussendungen einbezogen wird.

14. Verfahren nach den zusammengefaßten Ansprüchen 11 bis 13, dadurch gekennzeichnet, daß:
- der Schritt b) ferner für wenigstens eine gegebene Frequenz die Berechnung der Varianzen $(r^J_k)$ der Aussendungen enthält, welche jeweils einer Frequenz $(F_j$ der verschiedenen Sender (k) entsprechen, gemittelt über die entsprechende Rechteckschwingung,
- der Schritt c) ferner die Berechnung der Qualitäten $(\alpha_k^J)$ umfaßt, welche den genannten Varianzen $(r_k^J)$ entsprechen, sowie die über die verschiedenen Sender (k) gebildete Summe $(\alpha^J)$ der Varianzen $(\alpha^J_k)$ entsprechend einer Frequenz $(F_j)$, so daß die genannte Wichtung verwirklicht wird.

## Claims

1. Compensation method for a local clock, consisting in:
- by means of a reception circuit (2) at least one transmission ($F_0$, $F_1$ of $F_2$) is received in the form of a rectangular signal from at least one transmitter piloted by a high precision clock;
- by means of a synchronization circuit (4) an at least approximate synchronization with the rectangular transmission signals from the transmitter is produced; - by means of a comparing circuit (1) said transmission is sampled with a sampling frequency($F_E$) which is an integral divisor of the frequency (F) of the local clock (3) and a comparison between the frequency of the local clock and that of said transmission is deduced therefrom;
- by means of a correction circuit (5) the frequency of the local clock (3) is corrected as a function of the result of said comparison,
the sampling frequency ($F_E$) being defined in this method by dividing that of the clock and being nominally equal to that of said transmission or to an integer divisor thereof, and wherein a plurality of transmissions of different frequency are received in the form of rectangular signals from at least one transmitter and wherein said sampling frequency ($F_E$) is an integer common divisor of said transmission frequencies ($F_0$, $F_1$,$F_2$), characterized in that at the end of the sampling operation pulse couples ($a_0$,$b_0$; $a_1$, $b_1$; $a_2$,$b_2$) are obtained the recurrence of which corresponds to said sampling frequency (F) in order to produce a sampling ($a_0$, $a_1$, $a_2$) and a quadrature sampling ($b_0$, $b_1$, $b_2$) for a given frequency ($F_0$, $F_1$ or $F_2$, respectively), and in that the time shift between said sampling frequency ($F_E$) and at least one frequency of at least one transmission ($F_0$, $F_1$ or $F_2$) is periodically calculated.

2. Method according to claim 1, characterized in that the comparing circuit (1) is arranged to produce at least one calculation of the slope of the time shift averaged over a given duration for at least one given frequency and a given transmitter.

3. Method according to claim 1, characterized in that the reception circuit (2) is arranged to receive the transmissions of the OMEGA system and in that the comparing circuit (1) is arranged to perform said calculations over useful transmission bands of the rectangular signals of the OMEGA formats.

4. Method according to claim 3, characterized in that the comparing circuit (1) is arranged to produce at least one calculation of the slope of the time shift averaged over a given duration for a given frequency and a plurality of transmitters by compensation of the relative shifts between the transmissions received from the different transmitters.

5. Method according to claim 4, characterized in that the comparing circuit (1) is arranged to produce a plurality of said calculations of the slope of time shift averaged over a given duration, each for a given frequency at a plurality of transmitters, and to calculate the average of said slopes, said comparison being constituted thereby.

6. Method according to any of claims 3 to 5, characterized in that the synchronization is ensured by calculation with a given pitch of the quality summed over a preceding interval of the order of 625 ms and cumulated modulo 1.25s, and by determination of the moment where said cumulated quality is maximum, in a manner to produce the synchronization over said useful band.

7. Comparing device for performing the method of any of the preceding claims, characterized in that the correction is ensured by a correction circuit (5) comprising an integral controller (R) receiving a signal from the comparing circuit and acting on the control voltage of a control circuit (CO) associated with the clock (3) to be compensated.

8, Comparing device for performing the method of any of claims 2 to 6, characterized in that said comparison is ensured by a comparing circuit (1) receiving the signals of a sampling circuit (CE) after digitalization (NUM), in that the sampling circuit (CE) receives signals (F) from a time base (BT) dividing the pulses of the clock to be compensated (CO) in a given ratio, and in that the comparing circuit is arranged to modify the division ratio of the time base in a manner to compensate for said shift.

9. A radio navigation device for the movable object position determination, characterized in that it comprises a compensation device according to any of the preceding claims.

10. Method according to any of claims 1 to 6, performed in a radio navigation device for the movable object position determination, characterized in that the correction of the frequency of the local clock is ensured by the periodic calculation, by recurrence, of the absolute time (T) expired since a given origin, from the calculations of the relative phases between the transmissions of at least one frequency originating from different stations and from the frequency of the local clock, and thus by compensation of the phase of the frequency compensated local clock.

11. Method according to claim 10, characterized in that the periodic calculation of the absolute time is performed by the following operations interleaved with the frequency correction of the local clock for at least one frequency and a plurality of stations:

a) acquisition of samples of the received signals,
b) calculation of the phases ($\Phi_k^j$) of the received signals with respect to the compensated local clock,
c) calculation of the phase slopes of the received signals ($d\Phi_k^j/dt$),
d) calculation of the number of cycles received from the stations with respect to an imaginary focal point station ($X_k^j$),
e) calculation of the frequency (H) of the local clock and of the cycle number of the focal point station ($X_g^j$,
f) calculation of the absolute time (T).

12. Method according to claim 10 or 11, characterized in that the correction is ensured by said periodic calculation of the absolute time with a weighting of said phases of the transmissions of same frequency ($F_g^j$ originating from different stations (k).

13. Method accordng to claim 11, characterized in that said weighting introduces the quality of the received transmissions.

14. Method according to the combined claims 11 to 13, characterized in that:
- step b) further comprises for at least a given frequency the calculation of the variances ($r_k^j$) of the transmissions each corresponding to a frequency ($F_j$) of different transmitters (k) averaged over the corresponding rectangular signal,
- step c) further comprises the calculation of the qualities ($\alpha_k^j$) corresponding to said variances ($r_k^j$) as well as the sum ($\alpha^j$) over the different transmitters (k) of the variances ($\alpha_k^j$) corresponding to a frequency ($F_j$) in a manner to perform said weighting.

15

0 079 280

# FIG_1

ANTENNE

# FIG_11

ANTENNE

1

# FIG_2

|   | 0,9s. | 1,0 s | 1,1 s | 1,2 s | 1,1 s | 0,9 s | 1,2 s | 1,0 s |
|---|---|---|---|---|---|---|---|---|
| A | 10,2 | 13,6 | 11,33 |   |   |   |   |   |
| B |   | 10,2 | 13,6 | 11,33 |   |   |   |   |
| C |   |   | 10,2 | 13,6 | 11,33 |   |   |   |
| D |   |   |   | 10,2 | 13,6 | 11,33 |   |   |
| E |   |   |   |   | 10,2 | 13,6 | 11,33 |   |
| F |   |   |   |   |   | 10,2 | 13,6 | 11,33 |
| G | 11,33 |   |   |   |   |   | 10,2 | 13,6 |
| H | 13,6 | 11,33 |   |   |   |   |   | 10,2 |

10 s

# FIG_3

10 s

F0    A    B    D

# FIG_4

1,25 s

φ

0,625 s

# FIG_5

1,25 s

φ1    φ2

0,3 s    0,3 s

3

0 079 280

# FIG_6

$T_E = 1/F_E$

$F_E = 188,88 \, Hz$

CRENEAU $p$

$i = 1$, $2$, $3$, $4$

$a_0$ $b_0$ $a_1$ $b_1$ $a_2$ $b_2$

# FIG_8

$F_0$ $\phi AF_0$

$\phi AF_0$ $P$ $P'$ $\Delta X_{AB}$

$\phi BF_0$ $X'_{AB}$

$\Delta X_{AB}$

$\phi BF_0$ $X_{AB}$ $10\,sec$

# FIG_9

U.T. $\left(\dfrac{\Delta T_M}{\Delta t}\right)$ R CO

$F_0, F_1, F_2$ $F$ D

# FIG_10

U.T. $\left(\dfrac{\Delta T_M}{\Delta t}\right)$ R' CO

$F_0, F_1, F_2$ $F$ D

5

# FIG_7

$F_E = 188,88 \, Hz$

$T_E = 1/F_E \sim 5294 \, \mu sec$

$(0,25 + K_0)T_0 =$
$8,25 \times T_0$

$F_0$ — $10,2 \, KHz$

$a_0$     $b_0$

$\sim 809 \, \mu s$

$(0,25 + K_1)T_1 =$
$8,25 \times T_1$

$F_1$ — $11,33 \, KHz$

$a_1$     $b_1$

$\sim 729 \, \mu s$

$(0,25 + K_2)T_2 =$
$10,25 \times T_2$

$F_2$ — $13,6 \, KHz$

$a_2$     $b_2$

$\sim 754 \, \mu s$

| A | B | C |
|---|---|---|
| $\sim 809 \, \mu s$ | $\sim 729 \, \mu s$ | $\sim 1467 \, \mu s$ |